# EUROPEAN PATENT APPLICATION

(11) **EP 1 056 172 A2**
(43) Date of publication of application: **29.11.2000**
(21) Application number: 00111277.0
(22) Date of filing: 25.05.2000
(51) Int. Cl.: H01S 5/227

(54) **Manufacturing method of semiconductor laser**

(30) Priority: 25.05.1999 JP 14557899
(71) Applicant: NEC CORPORATION, Tokyo (JP)
(72) Inventor: Koui, Tomoaki, Minato-ku, Tokyo (JP)
(74) Representative: Betten & Resch

(57) **Abstract**

A manufacturing method of a semiconductor laser is provided, in which an uppermost surface of an electric current blocking buried structural portion can be formed in flat without making electric current blocking characteristics worse, and element characteristics can be improved in quality. Therefore, the surface migration length of a group III material species is controlled by respectively changing a pressure of the group V material, a growth temperature or both the pressure of the group V material and the growth temperature from an initial pressure and an initial temperature in an growing intermediate step of selectively forming an electric current blocking layer 4 of the semiconductor laser by a atmospheric pressure MOVPE method. Thus, the uppermost surface of a buried structural portion is formed in flat.

## Description

### BACKGROUND OF THE INVENTION

### 1. Field of the Invention

The present invention relates to a manufacturing method of a semiconductor laser, and more particularly, to a manufacturing method of a semiconductor laser for flattening an uppermost surface of a buried structural portion in which an electric current blocking layer is selectively buried and grown by controlling the surface migration length of a group III material species.

### 2. Description of the Related Art

It is conventionally known that high yield is obtained in element characteristics without etching a substrate in a semiconductor laser for optical communication manufactured by using a narrow width selective growth technique.

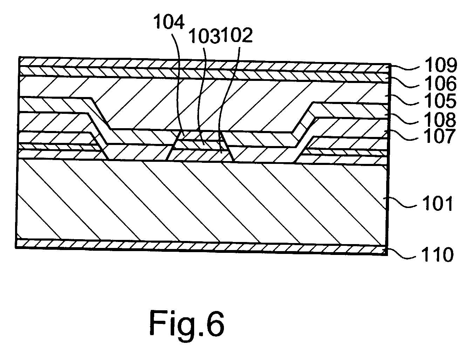

For example, in the manufacturing method of a semiconductor laser disclosed in Japanese Patent Application Laid-Open No. Hei 6-104527, both sides of an active layer formed by using the narrow widthselective growth technique without etching the substrate are buried in the electric current blocking layer in a structure of the semiconductor laser (a conventional example 1). Fig. 6 is a cross-sectional view showing the structure of the semiconductor laser described in the conventional example 1.

As shown in Fig. 6, a pair of SiO2 stripe masks is formed on the surface of a (100) n-type InP substrate 101. Thereafter, a double hetero (DH) structural portion is sequentially formed by selective growth in a MOVPE (Metal Organic Vapor Phase Epitaxy) method in an area except for this stripe mask. The double hetero structural portion is formed by an n-type InP clad layer 102, a multiple quantum well active layer 103 constructed by an InGaAs well and an InGaAsP barrier, and a p-type InP clad layer 104. Thereafter, the above stripe mask is removed and the SiO2 stripe mask is again formed only on an active area of the p-type InP clad layer 104. Then, a p-type InP blocking layer 107 and an n-type InP blocking layer 108 are sequentially selectively buried and grown in an area except for this active area. Further, after the stripe mask is removed, a p-type InP blocking layer 105 and a p-type InGaAs contact layer 106are selectively grown on an entire face. Thus, with respect to a wafer surface formed by three times of crystal growths, a p-type electrode 109 is formed on a surface of the p-type InGaAs contact layer 106 and an n-type electrode 110 is formed on the other wafer surface.

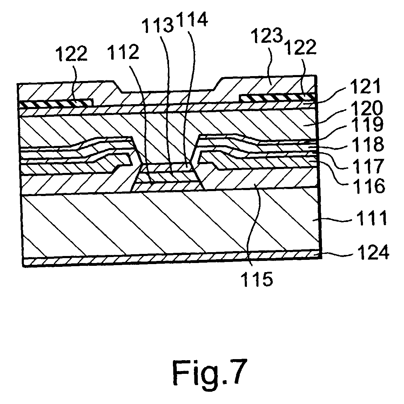

In a semiconductor device disclosed in Japanese Patent Application Laid-Open No. Hei 8-330676, both sides of an active layer formedby selective growth using the metal organic vapor phase epitaxy method are buried by a pnpn electric current blocking structure andan n-type electric current blocking layer is covered with a p-type layer (a conventional example 2). Fig. 7 is a cross-sectional view showing the structure of an optical semiconductor device described in the conventional example 2.

As shown in Fig. 7, a pair of SiO2 stripe masks extending in a direction of [011] is formed at an interval of 1.5 µ m on a p-type InP substrate 111. A p-type InP clad layer 112, an undoped InGaAsP/InGaAsP MQW (Multiple Quantum Well) active layer 113 and one portion of an n-type InP clad layer 114 are formed in an area of this 1.5 µm by selective growth using the MOVPE method. Thereafter, the SiO2 stripe mask is removed and the SiO2 stripe mask is again formed only on an upper face of the n-type InP clad layer 114. Both sides of this active layer are buried by a p-type InP layer 115 and an n-type InP layer 116. A p-type inversion layer 117 is then formed on a surface of the n-type InP layer 116, and a p-type InP layer 118 and an n-type InP layer 119 are sequentially grown so that apnpn electric current blocking structure is formed. Next, after the stripe mask is removed, an n-type InP layer 120 and an n-type InGaAsP cap layer 121 are buried and grown. An n-type electrode 123is formed on a surface of the n-type InGaAsP cap layer 121 thus formed through a dielectric insulating film 122, and a p-type electrode 124 is formed on the other face.

Thus, when the pnpn electric current blocking layers (115 to 119)are buried and grown on both the sides of the active layer, n-n connection can be prevented by inverting one portion of the n-type layer to the p-type by a means of open pipe diffusion of Zn performed within a MOVPE growing furnace.

In the conventional examples 1 and 2 shown here, a growing operation is performed under a single growing condition without changingthe growing condition during the growth when the electric currentblocking layer is grown by using the MOVPE method.

However, it is very difficult to flatten the uneveness of a channel area formed on both the sides of the DH structural portion by the atmospheric pressure MOVPE method to a desirable flat shape with good reproducibility by the single growing condition.

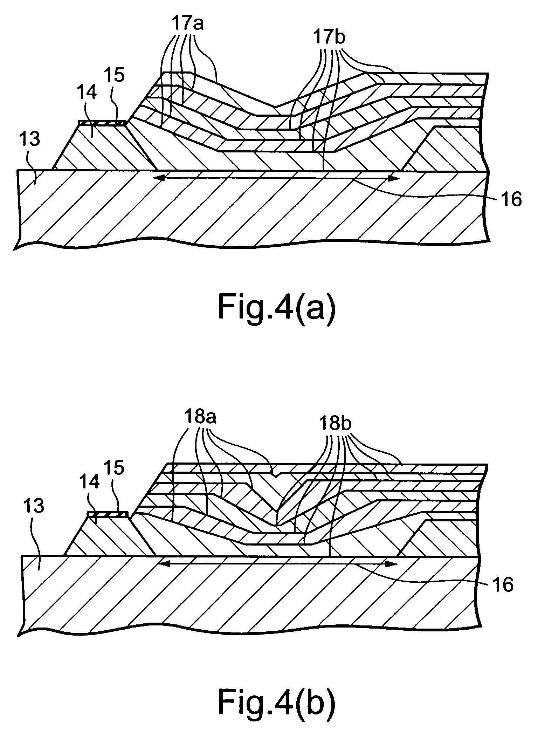

Figs. 4(a) and 4(b) are views showing forming processes of the electric current blocking layer of the semiconductor laser. Fig. 4(a) is across-sectional view in a growing condition in which the surface migration length is short. Fig. 4(b) is a cross-sectional view in a growing condition in which the surface migration length is long. In this case, the "surface migration length" means a distance at which the group III material species supplied to the substrate can move on a (100) face until this raw material species is taken into this substrate, or a distance at which the raw material species can move on the (100) face until the raw material species contributes to the growth. Figs. 4(a) and 4(b) show a process in which an SiO2 stripe mask 15 for preventing growth is formed only on a top of aDH structural portion 14 on an InP substrate 13 selectively growing the DH structural portion 14 thereon, and an electric current blocking layer is formed in a channel area 16 on both sides of this DH structural portion 14. For example, as shown in Fig. 4(b), when the first half of the electric current blocking layer constructed by a p-type InP layer is grown by using the growing condition of along migration length, the growth of a higher order face 18a suchas a (311) face is accelerated so that the growth rate of a (100)face 18b is relatively reduced and the channel area 16 is buried by the higher order face growth. Therefore, a final shape is set to be flat, but the higher order face growth becomes dominant in this process. However, it is reported by R. Bhat, et. al. (Journal of Crystal growth, Vol. 107, (1991), pp. 772-778) that carrier concentration greatly changes in accordance with a face azimuth. In particular, when the higher order face growth is dominant in the p-type InP layer, doping efficiency is reduced and electric current blocking characteristics become worse so that elements are deteriorated.

In contrast to this, when the buried second half of growing constructed by the n-type InP layer is grown under the growing condition of a short migration length, no growth rate is almost changed on the higher order face 17a and the (100) face 17b as shown in Fig.4(a). Therefore, a problem exists in that no uppermost surface of the buried structural portion can be formed in flat since the growth is continued while a gentle irregular shape is maintained.

Further, when an intermediate growing condition is attempted to found, the migration length is also changed with the doping concentration. Therefore, a problem also exists in that the growing condition must be changed whenever change in element structure occurs.

### SUMMARY OF THE INVENTION

The present invention has been made in view of such problems, and therefore has an object of the present invention is to provide a manufacturing method of a semiconductor laser in which an uppermost surface of an electric current blocking buried structural portion can be formed in flat by controlling the surface migration length of a group III material species without making electric current blocking characteristics worse, and element characteristics can be improved in quality.

A manufacturing method of a semiconductor laser according to the present invention is comprised of the steps of: forming stripe masks on a first conductive type semiconductor substrate; selectively growing a double hetero structural portion including a semiconductor active layer in an area interposed between said stripe masks; removing said stripe masks and forming a growth preventing mask on an upper face of said growing layer selectively grown; selectively forming a electric current blocking layer of a second conductive type electric current blocking layer as a lower layer and a first conductive type electric current blocking layer as an upper layer on an area uncovered with said growth preventing mask; and removing said growth preventing mask and sequentially growing a second conductive type clad layer covering the entire substrate and an electrode contact layer, and is characterized in that an uppermost surface of a buried structural portion of said electric current blocking layer is flattened by controlling the surface migration length of a group III material species in the forming process of said electric current blocking layer.

If said first conductive type is an n-type and said second conductive type is a p-type, said electric current blocking layer is grown in the step of selectively forming said electric current blocking layer under a growing condition in which the surface migration length of said group III material species of said second conductive type electric current blocking layer in the growing first half is shorter than that of said first conductive type electric currentblocking layer in the second half of growing.

In the present invention, the growth of a higher order face of the electric current blocking layer constructed by a p-InP layer is restrained by using a growing condition in which said surface migration length in the growing first half is shorter than that in the second half of growing. Accordingly, a reduction in doping efficiency is prevented and no electric current blocking characteristics are deteriorated. Further, since the higher order face is grown under the growing condition in which the surface migration length is long in the second half of growing, the higher order face growth is accelerated and a (100) face is easily formed. Therefore, the uppermost surface of the buried structural portion can be formed in flat.

If said first conductive type is a p-type and said second conductive type is an n-type, said electric current blocking layer is grown in the step of selectively forming said electric current blocking layer under a growing condition in which the surface migration length of said group III material species of said second conductive type electric current blocking layer in the growing first half is longer than that of said first conductive type electric current blocking layer in the second half of growing.

In the present invention, a reduction in doping efficiency and deterioration of the electric current blocking characteristics are prevented by restraining the growth of the higher order face of the electric current blocking layer constructed by the p-type InP layer. Further, the growth of the higher order face of the electric current blocking layer constructed by the n-type InP layer is accelerated so that the uppermost surface of the buried structural portion can be formed in flat.

The surface migration length of said group III material species may be also controlled in the step of selectively forming said electric current blocking layer by respectively changing a pressure of the group V material or a growth temperature from an initial pressure or an initial temperature during said growth.

In the present invention, the surface migration length of each ofthe p-type InP layer and the n-type InP layer during the growth can be controlled by changing the growing condition of said electric current blocking layer during the growth. Thus, it is possible to obtain stable element characteristics in which the uppermost surface is flat and distribution of carrier concentration is small.

Furthermore, it is desirable that a width of said stripe mask is set to be equal to or smaller than 200 µm, and an open width of said stripe mask is set to be equal to or smaller than 10 µm, and a period of said stripe mask is set to be equal to or smaller than1000 µm in the step of forming said stripe masks on said first conductive type semiconductor substrate.

### BRIEF DESCRIPTION OF THE DRAWINGS

In the accompanying drawings:
Fig. 1 is a cross-sectional view showing a structure of a semiconductor laser manufactured in accordance with a first embodiment of the present invention;
Figs. 2(a) to 2(e) are cross-sectional views showing a manufacturing method of the semiconductor laser in the first embodiment of the present invention in a process order;
Fig. 3 is a cross-sectional view showing the structure of the semiconductor laser in the first embodiment of the present invention after an electric current blocking layer is grown;
Figs. 4(a) and 4(b) are views showing forming processes of the electric current blocking layer of the semiconductor laser in the first embodiment of the present invention, in which Fig. 4(a) is a cross-sectional view in the growing condition of a short surface migration length, and Fig. 4(b) is a cross-sectional view in the growing condition of a long surface migration length;
Figs. 5(a) and 5(b) are cross-sectional views showing a relation of the migration length and the growing process in the first embodiment of the present invention;
Fig. 6 is a cross-sectional view showing the structure of a semiconductor laser described in Japanese Patent Application Laid-Open No. Hei 6-104527; and
Fig. 7 is a cross-sectional view showing the structure of an optical semiconductor device described in Japanese Patent Application Laid-Open No. Hei 8-330676.

### DETAILED DESCRIPTION OF THE PREFERRED EMBODIMENTS

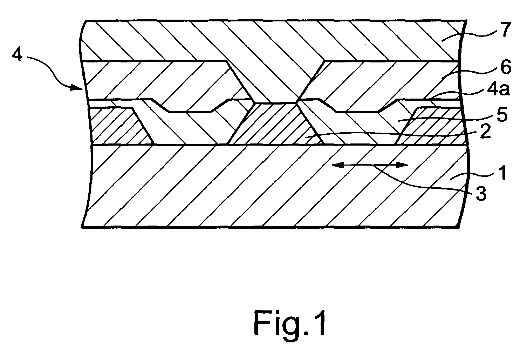

A manufacturing method of a semiconductor laser in accordance with an embodiment of the present invention will next be explained indetail with reference to the accompanying drawings. Fig. 1 is a cross-sectional view showing the structure of a semiconductor laser manufactured in accordance with a first embodiment of the present invention.

As shown in Fig. 1, in the semiconductor laser in this embodiment, a DH structural portion 2 is selectively grown in an area interposed between channel areas 3 on an n-type InP substrate 1. An SiO2stripe mask for preventing growth is formed in a self alignment manner only on a top of the DH structural portion 2. Further, an InP electric current blocking layer 4 is selectively buried and grown in a channel area 3, which is a electric current blocking layer composed of a p-type InP electric current blocking layer 5 as a lower layer and an n-type InP blocking layer 6 as an upper layer. InFig. 1, reference numeral 4a designates a growing interface as a boundary of the p-type InP electric current blocking layer 5 and the n-type InP electric current blocking layer 6. Next, the SiO2 stripe mask for preventing growth is removed from a top portion of the DH structural portion 2, and an InP clad layer 7 is buried and grown so as to cover an entire surface.

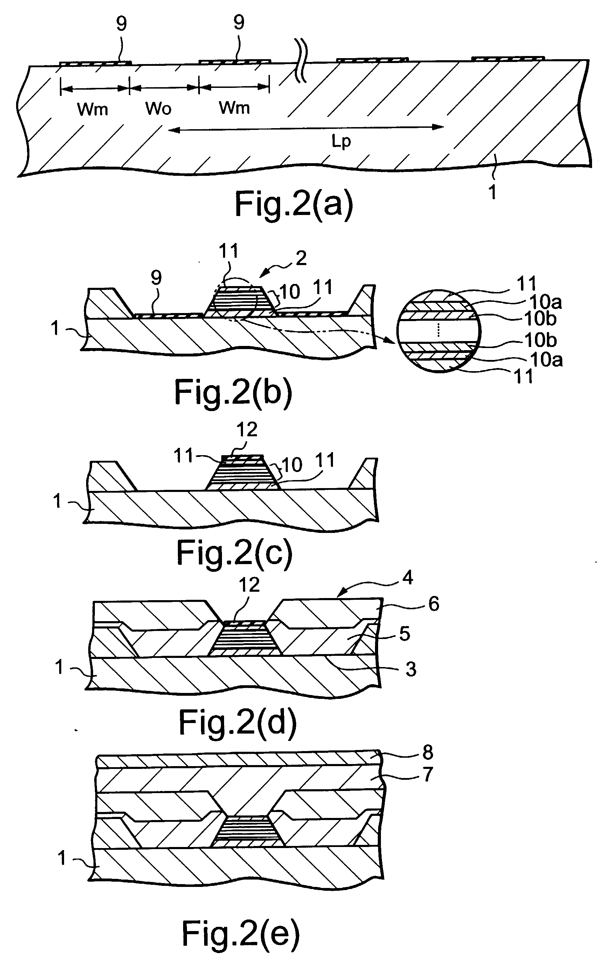

The manufacturing method of the semiconductor laser in the first embodiment of the present invention will next be explained with reference to Figs. 2(a) to 2(e). Figs. 2(a) to 2(e) are cross-sectional views showing the manufacturing method of the semiconductor laser in the first embodiment of the present invention in a process order. As shown in Fig. 2(a), a pair of SiO2 stripe masks 9 having a mask width Wm and an opening width Wo in a [011] direction is formed in a period Lp on an n-type InP substrate 1 having a (100) face on itssurface. At this time, Wm=0 to 200 µm, particularly from 0 to 50µm, is desirable. Wo=0 to 10 µm, and Wo from 0 to 5 µm is desirable. Lp=0 to 1000 µm, particularly from 100 to 500 µm, is particularly desirable.

As shown in Fig. 2(b), a DH structural portion 2 including an MQW structural portion 10 is selectively grown by a atmospheric pressure MOVPE method. In the MQW structural portion 10, a well layer 10ais an InGaAsP layer having 0.7% in compressive strain, 5 nm in film thickness, 7 in layer number and 1.27 µm in band gap wavelength. A barrier layer 10b is an InGaAsP layer having 8 nm in film thickness and 1.13 µm in band gap wavelength. InGaAsP-SCH (Separate Confinement Heterostructure) layers 11 having 60 nm in film thickness and 1.13 µm in band gap wavelength are arranged below and above the MQW structural portion 10.

As shown in Fig. 2(c), the above SiO2 stripe mask 9 is removed and an SiO2 stripe mask 12 is next formed in a self alignment manner only on an upper face of the DH structural portion 2. As shown in Fig. 2(d), an InP electric current blocking layer 4 is selectively buried and grown in a channel area 3 on both sides of the DH structural portion 2 by the atmospheric pressure MOVPE method.

Here, the structure of the InP electric current blocking layer 4 is set to a laminated structure of a p-type InP electric current blocking layer 5 (5x1017 cm-3 in carrier concentration and 0.4 µm in film thickness) and an n-type InP electric current blocking layer 6 (3x1018 cm-3 in carrier concentration and 0.6 µm in film thickness).

As shown in Fig. 2(e), the above SiO2 stripe mask 12 is next removed and an InP clad layer 7 (1x1018 cm-3 in carrier concentration and 4.5 µm in film thickness) and an InGaAs electrode contact layer8 (1x1019 cm-3 in carrier concentration and 0.5 µm in film thickness) covering the entire substrate are buried and grown by the atmospheric pressure MOVPE method.

When the electric current blocking layer is grown on the irregular substrate having the DH structural portion formed by the selective growth in a growing condition for shortening the surface migration length, the electric current blocking layer is continuously grown while an irregular shape is held. In contrast to this, when the electric current blocking layer is grown under a growing condition for lengthening the surface migration length, the irregular shape of the electric current blocking layer is early buried and an uppermost surface is flattened. Therefore, a growing sectional shape has features.

Accordingly, the surface migration length of a group III material species is controlled to flatten the shape of the uppermost surface during the growth of the InP electric current blocking layer 4 without making electric current blocking characteristics worse. Inthis embodiment, a pressure of the group V material is set to a high pressure of 6.0 Torr to continue the growth while the irregular shape is held in the first half of the growth (p-type InP electric current blocking layer 5). Thus, the surface migration length of the group III material species is shortened. Further, the pressure of the group V material is set to a low pressure of 0.6 Torr to grow the blocking layer such that the irregular shape is early buried and the uppermost surface is flattened in the second half of the growth (n-type InP electric current blocking layer 6). Thus, the surface migration length of the group III material species is lengthened.

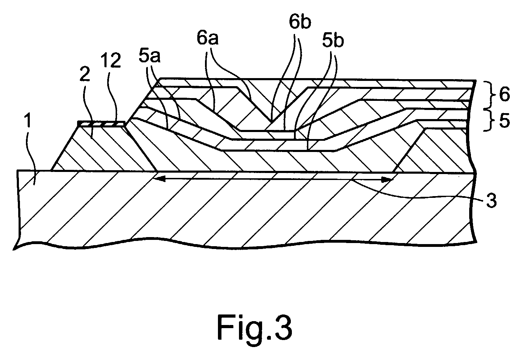

The reasons for this will be explained with reference to Fig. 3. Fig. 3 is across-sectional view showing a substrate structure after the blocking layer is grown and extracts only a portion required in the explanation.

First, when the blocking layer is grown under the condition of a short migration length in the first half of the growth constructed by the p-type InP electric current blocking layer 5, the difference between the growth rate of a higher order face 5a such as a (311) face easy to take-in the group III material species and the growth rate of a (100) face 5b of the p-type InP electric current blocking layer 5 is small so that the channel area 3 is relatively gently buried.

In contrast to this, when the blocking layer is grown under the condition of a long migration length in the second half of the growth constructed by the n-type InP electric current blocking layer 6, the growth rate of a higher order face 6a is higher than that of a (100) face 6b of the n-type InP electric current blocking layer 6 so that the channel area 3 is easy to be early buried and the flat shape on the uppermost surface can be realized.

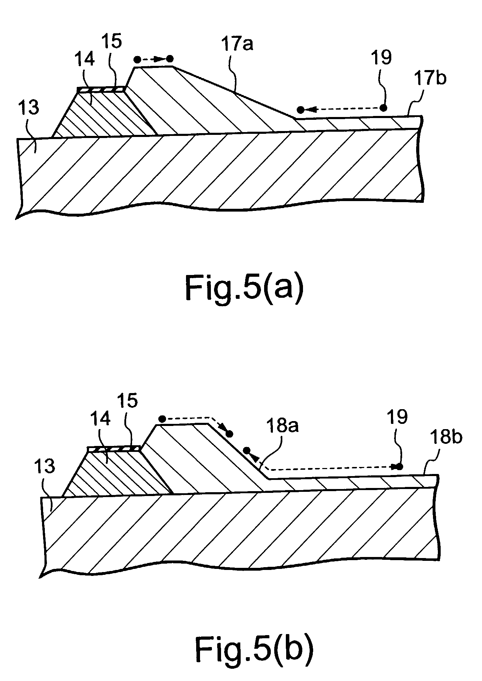

An operation principle of the above growing process will next be explained with reference to Figs. 4(a) to 5(b). Figs. 4(a) and 4(b) are cross-sectional views showing forming processes of an electric current blocking layer of the semiconductor laser. Figs. 5(a) and 5(b) are cross-sectional views showing a relation of the migration length and the growing process. In a process of Figs. 4(a) and 4(b), an SiO2 stripe mask 15 for preventing growth is formed only on a top of a DH structural portion 14 on an InP substrate 13 on which the DH structural portion 14 is selectively grown. An electric current blocking layer is formed in a channel area 16 on both sides of this DH structural portion 14. Similarly to Figs. 4(a) and 4(b), Figs. 5(a) and 5(b) show the relation of the substrate of a group III material species 19 supplied to the InP substrate 13 and the surface migration length in the process in which the electric current blocking layer is formed in the channel area 16 on the both sides of the DH structural portion 14.

As shown in Fig. 5(a), when the surface migration length is short, the group III material species 19 supplied onto a (100) face 17b contributes to the growth before this raw material species is takenon a higher order face 17a. Accordingly, growth rate on the higher order face 17a and the (100) face 17b are approximately equal to each other. Therefore, as shown in Fig. 4(a), the electric current blocking layer is continuously grown while a gentle irregular shape is left.

In contrast to this, when the surface migration length is long as shown in Fig. 5(b), the group III material species 19 supplied onto a (100) face 18b is easily taken onto a higher order face 18a having a high growth rate and the growth rate of the higher order face 18a is higher than that of the (100) face 18b. Therefore, as shown in Fig. 4(b), the higher order face 18a is pushed out of both sides of the channel area 16 so that a hollow portion of the channel area is buried and only the (100) face having a low growth rate is left later.

A forming method of the structure of the InP electric current blocking layer 4 of Figs. 2(a) to 2E will next be explained. The surface migration length of the group III material species can be controlled by a pressure of the group V material. Namely, the surface migration length of the group III material species can be shortened by increasing the pressure of the group V material in comparison with a low pressure of the group V material. In this embodiment, the pressure of the group V material is set to 6.0 Torr during the growth of the p-type InP electric current blocking layer 5 and is set to 0.6 Torr during the growth of the n-type InP electric current blocking layer 6. Accordingly, the surface migration length of the group III material species is greatly changed by changing the pressure of the group V material ten times.

In the other growing conditions, a growth temperature of the p-type InP electric current blocking layer 5 is set to 625 oC and the growth rate is set to 1.7 µm /h. A V/III (5/3) ratio of the supplied group III material and a group V material is set to 300. Further, the n-type InP electric current blocking layer 6 is set to 625oC in growth temperature, 1.7 µm/h in growth rate and 30 in V/III (5/3) ratio.

In this embodiment, tri-methyl-indium (TMI) is used as the group III material and phosphine (PH3) is used as the group V material. Further, di-methyl-zinc (DMZn) is used as a p-type dopant and di-silane (Si2H6) is used as an n-type dopant and a growing pressure is set to a atmospheric pressure.

A second embodiment of the present invention will next be explained. In the first embodiment, the migration length is controlled by directly changing the pressure of the group V material. However, there is a method for changing the growth temperature in a range capable of performing crystal growth as a separate means for changing the pressure of the group V material. Decomposition efficiency of PH3 as a group V material greatly depends on temperature and decomposition of PH3 is restrained by a reduction in growth temperature. Therefore, a substantial pressure of the group V material effectively contributing to the growth is reduced.

For example, when the growth temperature is reduced by about 50oC from 625oC to 575oC, the decomposition efficiency of PH3 becomes about 1/10. Namely, it is possible to obtain effects similar to those in a case in which a PH3 flow ratio is substantially reduced to 1/10.

In an explanation using Fig. 2(d), the growth temperature during the growth of the p-type InP electric current blocking layer 5 is set to 625 oC and the growth temperature during the growth of the n-type InP electric current blocking layer 6 is set to 575oC in this embodiment.

In the other growing conditions, the p-type InP electric current blocking layer 5 is set to 6.0 Torr in pressure of the group V material, 1.7 µm/h in growth rate and 300 in V/III (5/3) ratio, and the n-type InP electric current blocking layer 6 is set to 6.0 Torr in pressure of the group V material, 1.7 µm/h in growth rate and 300 in V/III (5/3) ratio.

A third embodiment of the present invention will next be explained. In the growing condition for determining the growth of the electric current blocking layer, the pressure of the group V material is changed in the first embodiment and the growth temperature is changed in the second embodiment. In this embodiment, the surface migration length of the group III material species is further freely controlled by changing two growing conditions of the pressure of the group V material and the growth temperature as a combining method of the first and second embodiments.

For example, when a first conductive type is set to the n-type and the above second conductive type is set to the p-type, the surface migration length of the group III material species in the first half of growing is controlled under a growing condition in which this surface migration length is shorter than the surface migration length in the growing second half. Therefore, the pressure of the group V material and the growth temperature are controlled by increasing the pressure of the group V material and the growth temperature in the first half of growing in comparison with the growing second half. Thus, the surface migration length of the group III material species can be more freely controlled.

A fourth embodiment of the present invention will next be explained. An element structure on the n-type InP substrate is described in the first to third embodiments of the present invention. However, this embodiment relates to an element structure on a p-type InP substrate.

Namely, in the n-type InP layer in the first half of growing of an electric current blocking layer, the electric current blocking layer is grown under a growing condition for lengthening the surface migration length so that the growth of a higher order face is accelerated and a flat shape is formed. In the p-type InP layer in the growing second half, the electric current blocking layer is grown under a growing condition for shortening the surface migration length so that the growth of the higher order face is restrained and a reduction in doping efficiency can be prevented. Thus, stable element characteristics can be obtained without deteriorating electric current blocking characteristics.

As mentioned above in detail, in accordance with the present invention, an electric current blocking buried structural portion can be formed in flat by controlling the surface migration length of the group III material species. Further, a channel area is relatively gently buried in the first half of growing of an InP electric current blocking layer. Therefore, a (100) face is easily formed and a distribution of carrier concentration is reduced and stable element characteristics are obtained.

## Claims

1. A manufacturing method of a semiconductor laser, comprising the steps of: forming stripe masks on a first conductive type semiconductor substrate; selectively growing a double hetero structural portion including a semiconductor active layer in an area interposed between said stripe masks; removing said stripe masks and forming a growth preventing mask on an upper face of said growing layer selectively grown; forming an electric current blocking layer of a second conductive type electric current blocking layer as a lower layer and a first conductive type electric current blocking layer as an upper layer on an area uncovered with said growth preventing mask; and removing said growth preventing mask and sequentially growing a second conductive type clad layer covering the entire substrate and an electrode contact layer; wherein an uppermost surface of a buried structural portion of said electric current blocking layer is flattened by controlling the surface migration length of a group III material species in the forming process of said electric current blocking layer.

2. A manufacturing method of a semiconductor laser according to claim 1, wherein said first conductive type is an n-type and said second conductive type is a p-type.

3. A manufacturing method of a semiconductor laser according to claim 1 or 2, wherein said electric current blocking layer is growing the step of selectively forming said electric current blocking layer under a growing condition in which the surface migration length of said group III material species of said second conductive type electric current blocking layer in the first half of growing is shorter than that of said first conductive type electric current blocking layer in the growing second half.

4. A manufacturing method of a semiconductor laser according to claim 1, wherein said first conductive type is a p-type and said second conductive type is an n-type.

5. A manufacturing method of a semiconductor laser according to claim 1 or 4, wherein said electric current blocking layer is grownin the step of selectively forming said electric current blocking layer under a growing condition in which the surface migration length of said group III material species of said second conductive type electric current blocking layer in the first half of growing is longer than that of said first conductive type electric current blocking layer in the growing second half.

6. A manufacturing method of a semiconductor laser according to any one of claims 1 to 5, wherein the surface migration length of said group III material species is controlled in the step of selectively forming said electric current blocking layer by changing a pressure of the group V material from an initial pressure during said growth.

7. A manufacturing method of a semiconductor laser according to any one of claims 1 to 5, wherein the surface migration length of said group III material species is controlled in the step of selectively forming said electric current blocking layer by changing a growth temperature from an initial temperature during said growth.

8. A manufacturing method of a semiconductor laser according to any one of claims 1 to 5, wherein the surface migration length of said group III material species is controlled in the step of selectively forming said electric current blocking layer by respectively changing a pressure of the group V material and a growth temperature from an initial pressure and an initial temperature during said growth.

9. A manufacturing method of a semiconductor laser according to any one of claims 1 to 8, wherein a width of said stripe mask is set to be equal to or smaller than 200 µm, and an open width of said stripe mask is set to be equal to or smaller than 10 µm, and a period of said stripe mask is set to be equal to or smaller than 1000 µm in the step of forming said stripe masks on said first conductive type semiconductor substrate.
